# FASCICULE DE BREVET EUROPEEN

(11) **EP 3 435 399 B1**
(45) Date de publication et mention de la délivrance du brevet: **12.02.2020**
(21) Numéro de dépôt: 18185134.6
(22) Date de dépôt: 24.07.2018
(51) Int. Cl.: H01H 89/06

(54) **DISPOSITIF ÉLECTRIQUE POUR L'ALIMENTATION ÉLECTRIQUE D'APPAREILS ÉLECTRIQUES DE PUISSANCE**
ELEKTRISCHE VORRICHTUNG ZUR BESTROMUNG EINES ELEKTRISCHEN GERÄTES
ELECTRICAL APPARATUS FOR POWERING ELECTRICAL DEVICES

(30) Priorité: 25.07.2017 FR 1757041
(43) Date de publication de la demande: 30.01.2019
(73) Titulaire: Schneider Electric Industries SAS, 92500 Rueil-Malmaison (FR)
(72) Inventeur: DELBAERE, Stephane, 38050 Grenoble Cedex 09 (FR); BAURAND, Gilles, 38050 Grenoble Cedex 09 (FR)
(74) Mandataire: Lavoix

(56) Documents cités:
- EP-A1- 2 015 341
- EP-A1- 2 202 848
- FR-A1- 2 761 539

## Description

La présente invention concerne un dispositif électrique pour l'alimentation électrique d'appareils électriques de puissance.

Dans le domaine de l'alimentation électrique d'appareils de puissance, tels que des moteurs électriques, il est connu d'utiliser des dispositifs électriques qui permettent de de fournir de façon contrôlée une alimentation électrique à un ou plusieurs appareils de puissance. Par exemple, plusieurs moteurs électriques sont connectés à un tel dispositif électrique, pour former un ensemble dit de départ moteur. Ce dispositif est configuré pour recevoir un courant électrique d'alimentation et pour le redistribuer vers plusieurs lignes d'alimentation chacune connectée à un des moteurs électriques. Ce dispositif permet d'assurer une protection électrique de chacun des moteurs, par exemple au moyen d'un disjoncteur, ainsi qu'un pilotage de chacun de ces moteurs, par exemple en permettant une interruption sélective du courant qui circule dans les lignes d'alimentation. Un exemple d'un tel dispositif électrique est décrit dans EP-1318537-B1.

Ce dispositif connu ne donne cependant pas entière satisfaction compte tenu des usages contemporains, notamment en raison d'une flexibilité d'utilisation réduite. Toute modification de l'ensemble de départ moteur pour ajouter une fonctionnalité nécessite une modification complète du dispositif, ce qui est contraignant.

D'ailleurs, le document FR 2 761 539 A1 divulgue un dispositif électrique pour l'alimentation électrique de plusieurs appareils de puissance, comportant :
- un support fixe ;
- des terminaux d'entrée pour recevoir un courant électrique polyphasé ;
- un premier module , comprenant une première ligne de puissance connectée aux terminaux d'entrée , cette ligne de puissance comprenant un disjoncteur électrique ;
- un deuxième module amovible, comprenant :
   - une seule deuxième ligne de puissance, connectée à la première ligne de puissance par l'intermédiaire d'un circuit de distribution électrique configuré pour distribuer le courant électrique polyphasé depuis la première ligne de puissance vers la seule deuxième ligne de puissance ;
   - une interface de connexion pourvue de connecteurs de sortie connectés à la deuxième ligne de puissance ;
- un élément amovible contenant un équipement électrique destiné à être connecté à un appareil électrique de puissance par l'intermédiaire de terminaux de sortie de cet élément amovible, l' élément amovible étant déplaçable entre une position assemblée, dans laquelle il est connecté à l'interface de connexion, et une position retirée dans laquelle il est retiré de l'interface de connexion, l'équipement électrique étant connecté à la deuxième ligne de puissance par l'intermédiaire d'un connecteur de sortie de l'interface de connexion lorsque l'élément amovible est dans la position assemblée.

C'est à ces inconvénients qu'entend plus particulièrement remédier l'invention en proposant un dispositif électrique pour l'alimentation électrique de plusieurs appareils de puissance qui remédie aux inconvénients précités.

A cet effet, l'invention concerne un dispositif électrique pour l'alimentation électrique de plusieurs appareils de puissance. Ce dispositif comporte :
- un support fixe ;
- des terminaux d'entrée pour recevoir un courant électrique polyphasé ;
- un premier module, comprenant une première ligne de puissance connectée aux terminaux d'entrée, cette ligne de puissance comprenant un disjoncteur électrique ;
- un deuxième module amovible, comprenant :
   - des deuxièmes lignes de puissance, connectées à la première ligne de puissance par l'intermédiaire d'un circuit de distribution électrique configuré pour distribuer le courant électrique polyphasé depuis la première ligne de puissance vers chacune des deuxième lignes de puissance ;
   - un circuit de commande, programmé pour déclencher le disjoncteur en fonction de valeurs du courant électrique qui circule dans les deuxièmes lignes de puissance ;
   - une interface de connexion pourvue de connecteurs de sortie connectés aux deuxièmes lignes de puissance ;
- des éléments amovibles contenant chacun un équipement électrique destiné à être connecté à un appareil électrique de puissance par l'intermédiaire de terminaux de sortie de cet élément amovible,
chaque élément amovible étant déplaçable entre une position assemblée, dans laquelle il est connecté à l'interface de connexion, et une position retirée dans laquelle il est retiré de l'interface de connexion,
l'équipement électrique étant connecté à une des deuxièmes lignes de puissance par l'intermédiaire des connecteurs de sortie de l'interface de connexion lorsque l'élément amovible est dans la position assemblée,
le circuit de commande étant connecté à une interface de commande de l'équipement électrique de chaque élément amovible par l'intermédiaire d'une liaison de données grâce à l'interface de connexion pour envoyer un signal de commande à destination de cet équipement électrique.

Grâce à l'invention, la conception modulaire du dispositif électrique, notamment grâce aux premier et deuxième modules et aux éléments amovibles, permet d'isoler chaque fonction du dispositif électrique dans un module et/ou un élément amovible dédié. Cela permet de remplacer une partie du dispositif électrique indépendamment des autres parties, par simple extraction du module amovible ou de l'élément amovible, par exemple lors d'opérations de maintenance pour remplacer un élément défaillant ou pour remplacer un élément par exemple lorsqu'il est nécessaire d'ajouter de nouvelles fonctionnalités.

Selon des aspects avantageux mais non obligatoires de l'invention, un tel dispositif électrique peut incorporer une ou plusieurs des caractéristiques suivantes, prises isolément ou suivant toute combinaison techniquement admissible :
- L'élément électrique commandable est un contacteur à contacts séparables adapté pour sélectivement interrompre la circulation d'un courant électrique sur la deuxième ligne de puissance à laquelle il est connecté.
- L'élément électrique commandable est un inverseur de sens de marche ou de rotation ou un module d'entrée/sortie de données.
- L'interface de connexion comporte des logements chacun destiné à recevoir une portion de connexion d'un des éléments amovibles lorsque cet élément amovible est dans la position assemblée.
- Le deuxième module est connecté à un bus de données et le circuit de commande est programmé pour envoyer un signal de commande en fonction d'ordres de commande reçus depuis le bus de données.
- Chaque élément amovible comporte un terminal d'entrée de données pour recevoir un ordre de commande, ce terminal d'entrée de données étant raccordé à une première partie de liaison, et le deuxième module comporte une deuxième partie de liaison connectée à l'unité de commande.
- La portion de connexion de chaque élément amovible comporte des connecteurs de forme complémentaire à celle des connecteurs de sortie et formés en saillie par rapport à la portion de connexion, la connexion électrique entre l'équipement électrique et la deuxième de puissance correspondante étant assurée par l'intermédiaire de ces connecteurs.
- L'interface de connexion et la portion de connexion de chaque élément amovible comportent des dispositifs de guidage en translation de forme complémentaire l'un par rapport à l'autre pour assurer un déplacement en translation de cet élément amovible par rapport au deuxième module.
- Le premier module comporte un contacteur additionnel connecté à la première ligne de puissance et adapté pour être commandé par le circuit de commande.
- Le premier module est amovible.

L'invention sera mieux comprise et d'autres avantages de celle-ci apparaîtront plus clairement à la lumière de la description qui va suivre, d'un mode de réalisation d'un dispositif électrique donné uniquement à titre d'exemple et faite en référence aux dessins annexés dans lesquels :
- la figure 1 est une représentation schématique d'un dispositif électrique conforme à l'invention ;
- la figure 2 est un schéma synoptique du dispositif électrique de la figure 1 ;
- la figure 3 est une représentation schématique d'un élément amovible du dispositif électrique des figures 1 et 2 ;
- la figure 4 est un schéma synoptique d'un dispositif électrique selon un autre mode de réalisation de l'invention ;
- les figures 5 et 6 sont des schémas simplifiés d'une connexion entre un module de commande et un élément amovible du dispositif électrique selon le mode de réalisation, respectivement, des figures 2 et 4.

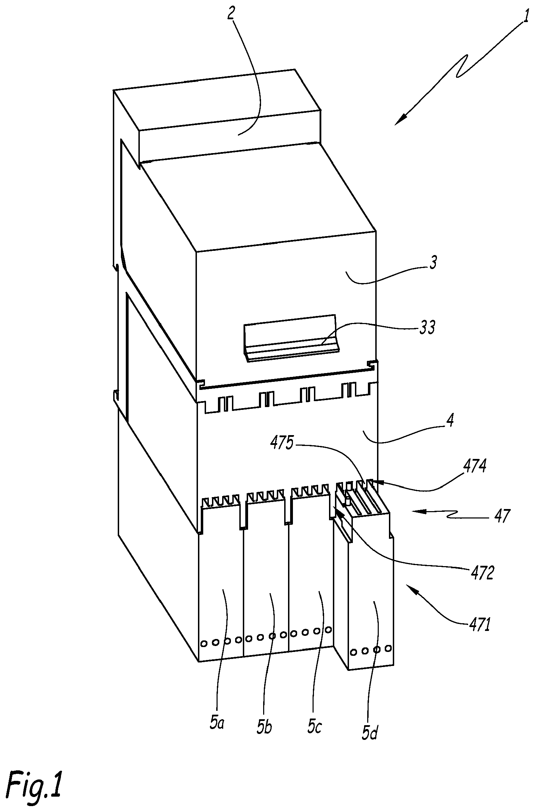

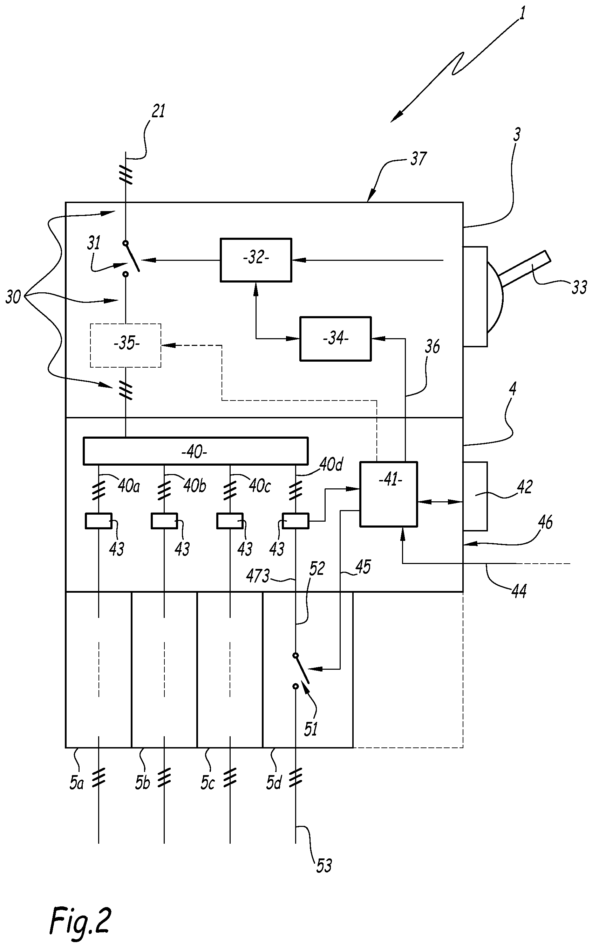

Les figures 1 et 2 représentent un dispositif électrique 1 pour commander l'alimentation électrique d'appareils électriques de puissance, tels que des moteurs électriques. Le dispositif 1 comporte ici une entrée d'alimentation électrique et plusieurs sorties d'alimentation électrique, entre lesquelles est redistribuée un courant d'alimentation électrique reçu sur l'entrée d'alimentation. Les sorties d'alimentation sont chacune connectée à un appareil de puissance pour alimenter électriquement celui-ci tout en assurant d'une part une protection contre des défauts électriques et d'autre part, autoriser l'interruption sélective de l'alimentation électrique de chacun de ces appareils de puissance.

Par exemple, le dispositif 1 est utilisé au sein d'un ensemble de départ moteur pour commander l'alimentation électrique de plusieurs moteurs électriques à courant alternatif.

Le dispositif 1 comporte un support fixe 2, ou embase, ainsi qu'un premier module 3, un deuxième module amovible 4 et des éléments amovibles 5a, 5b, 5c et 5d, ici au nombre de quatre. Le support fixe 2 est ici placé à l'arrière du dispositif 1 et installé au sein d'un tableau électrique ou d'une armoire électrique.

Dans cet exemple, le premier module 3 est amovible, c'est-à-dire qu'il est séparable, de façon réversible, du support fixe 2. En variante, le premier module 3 peut être attaché de façon non détachable avec le support fixe 2.

Le dispositif 1 comporte en outre des terminaux d'entrée 21 pour recevoir un courant électrique polyphasé, tel qu'un courant triphasé, destiné à alimenter les moteurs électriques. Les terminaux d'entrée 21 sont par exemple connectés à une source d'alimentation électrique extérieure au dispositif 1. Par exemple, pour un courant électrique triphasé, les terminaux d'entrée 21 sont formés par trois conducteurs électriques distincts, chacun associé à une phase du courant électrique.

Les terminaux d'entrée 21 sont ici disposés au moins partiellement à l'intérieur du support fixe 2. En variante, toutefois, d'autres agencements ont possibles, par exemple en disposant les terminaux d'entrée 21 dans le premier module 3.

Le premier module 3, par exemple nommé module de protection, a pour fonction de protéger le dispositif 1 et les appareils de puissance contre des défauts électriques, tel qu'un court-circuit ou un courant de surcharge. A cet effet, il comporte une première ligne de puissance 30 et un disjoncteur commandable 31.

La ligne de puissance 30 est destinée à être connectée électriquement aux terminaux 21 pour autoriser la circulation du courant électrique polyphasé. Par exemple, la ligne de puissance 30 comporte trois conducteurs électriques distincts. Le disjoncteur 31 est connecté sur la ligne de puissance 30 de manière à permettre une interruption du courant électrique sur cette ligne de puissance 30.

Le disjoncteur 31 comprend ici des contacts électriques séparables, par exemple un pour chaque conducteur de la ligne de puissance 30. Le disjoncteur 31 est, de façon connue, commutable entre un état fermé autorisant le passage du courant dans la ligne de puissance 30 et un état ouvert, dans lequel il inhibe le passage du courant. Ce disjoncteur 31 est de préférence équipé d'une chambre de coupure d'arc électrique associée à ces contacts séparables.

Dans cet exemple, le premier module 3 comporte également un mécanisme 32 de commande du disjoncteur 31, un organe de commande 33 manuelle du disjoncteur 31 et un déclencheur 34.

L'organe de commande 33 est ici un levier, ou maneton, placé sur une face extérieure du boîtier du module 3 de façon à pouvoir être actionné manuellement par un opérateur. En variante, l'organe 33 comporte une poignée rotative.

Le déclencheur 34 a pour fonction d'actionner automatiquement le mécanisme 32 de commande pour ouvrir le disjoncteur 31 en particulier en cas de détection d'un défaut de surcharge thermique ou de court-circuit.

En outre, le disjoncteur 31 est ici connecté au deuxième module 4 par l'intermédiaire d'une liaison de données 36, comme décrit ci-après.

Le premier module 3 est déplaçable, de façon réversible, entre une position assemblée, dans laquelle il est monté sur le support 2 solidairement avec celui-ci, et une position retirée, dans laquelle il est séparé du support 2. Par exemple, le support 2 comporte un premier logement de forme complémentaire à celle du premier module 3, à l'intérieur duquel ce premier module 3 est reçu lorsqu'il est dans la position assemblée.

A titre d'exemple, le déplacement entre les positions assemblée et retirée est réalisé par un mouvement de translation, de préférence selon une direction perpendiculaire au fond du support 2. A cet effet, le support 2 et le premier module 3 comportent des moyens de guidage en translation de forme complémentaire.

Dans la position assemblée, la ligne de puissance 30 est connectée aux terminaux d'entrée 21. Par exemple, chacun des conducteurs de la ligne de puissance 30 est raccordé électriquement à un terminal 21 correspondant. Dans la position retirée, la ligne de puissance 30 est déconnectée des terminaux d'entrée 21.

Par exemple, le premier module 3 comporte un boîtier extérieur 37 réalisé en un matériau isolant, tel qu'un matériau plastique moulé. Ce boîtier 37 est préférentiellement équipé d'organes de fixation qui permettent de solidariser le module 3 sur le support 2 dans la position assemblée.

A titre d'illustration, le premier module 3 présente une forme de pavé à base parallélépipédique. La largeur L1 du premier module 3, mesurée sur une face avant du premier module 3, est ici égale à 45mm. La face avant est ici la face du module 3 qui est disposée à l'opposé de la face arrière située au contact du support 2.

De préférence, le déplacement du premier module 3 entre les positions assemblée et retirée ne peut être réalisé que lorsqu'aucun courant électrique ne circule au sein du dispositif 1, par exemple grâce à des moyens de verrouillage dont l'état dépend de l'état du disjoncteur 31.

Optionnellement, le premier module 3 comporte un contacteur 35 commandable monté sur la ligne de puissance 30, dont le rôle est décrit dans ce qui suit.

Le deuxième module 4, ici nommé module de commande, a pour fonction d'assurer le pilotage et la supervision du dispositif 1. Il permet également d'assurer une distribution du courant électrique reçu depuis le premier module 3 en vue de son acheminement vers les appareils de puissance. Par exemple, le deuxième module 4 est placé en-dessous du premier module 3.

A cet effet, le deuxième module 4 comporte un circuit de distribution électrique 40 et des deuxièmes lignes de puissance 40a, 40b, 40c, 40d connectées à ce circuit 40 de distribution. Le circuit de distribution 40 est destiné à être connecté à la première ligne de puissance 30 pour répartir le courant polyphasé vers chacune des deuxièmes lignes de puissance 40a, 40b, 40c, 40d.

Dans cet exemple, chacune des deuxièmes lignes de puissance 40a, 40b, 40c, 40d comporte des conducteurs électriques distincts chacun associé à une phase du courant électrique. Les deuxièmes lignes de puissance 40a, 40b, 40c, 40d sont ici identiques entre elles. Les deuxièmes lignes de puissance 40a, 40b, 40c, 40d sont adaptées pour acheminer chacune un courant électrique d'alimentation depuis le circuit 40 vers un appareil électrique correspondant en aval du dispositif 1.

La connexion entre la première ligne de puissance 30 et le circuit de distribution 40 est par exemple assurée grâce à des terminaux intermédiaires fixes, non illustrés, faisant partie du support 2. Ces terminaux intermédiaires comportent par exemple plusieurs conducteurs électriques distincts, ici au nombre de trois, chacun associé à une phase du courant électrique.

Le deuxième module 4 est déplaçable, de façon réversible, entre une position assemblée, dans laquelle il est monté sur le support 2 solidairement avec celui-ci, et une position retirée, dans laquelle il est séparé du support 2. Par exemple, le support 2 comporte un deuxième logement, distinct du premier logement et de forme complémentaire à celle du deuxième module 4, dans lequel ce deuxième module 4 est reçu lorsqu'il est dans la position assemblée.

A titre d'exemple, le déplacement entre les positions assemblée et retirée est réalisé par un mouvement de translation, ici selon une direction perpendiculaire au fond du support 2, de façon analogue au déplacement du premier module 3. A cet effet, le support 2 et le deuxième module 4 comportent des moyens de guidage en translation complémentaires entre eux.

Dans la position assemblée, le circuit de distribution 40 est connecté aux terminaux intermédiaires du support 2. Par exemple, chacun des conducteurs de la ligne de puissance 30 est raccordé électriquement à un terminal intermédiaire correspondant du support 2. Dans la position retirée, le circuit de distribution 40 est déconnecté des terminaux intermédiaires.

On comprend ici que le circuit de distribution 40 est connecté à la première ligne de puissance 30, et donc aux terminaux d'entrée 21, uniquement lorsque le premier module 3 et le deuxième module 4 sont tous les deux dans leurs positions assemblés.

En variante, le circuit de distribution 40 n'est pas forcément situé dans le deuxième module 4. Par exemple, le circuit de distribution 40 est logé dans le premier module 3 ou dans le support fixe 2.

Dans cet exemple, le deuxième module 4 comporte un boîtier extérieur 46 réalisé en un matériau isolant, tel qu'un matériau plastique moulé, ici analogue au boîtier 37 du premier module 3. Ce boîtier 46 est préférentiellement équipé d'organes de fixation qui permettent de fixer le module 4 sur le support 2 dans la position assemblée.

A titre d'illustration, le deuxième module 4 présente une forme de pavé à base parallélépipédique. La largeur L2 du deuxième module 4, mesurée sur une face avant de ce module 4, est ici identique à celle du premier module 3, et donc égale à 45mm.

Le deuxième module 4 comporte un circuit de commande 41 pour piloter le fonctionnement du dispositif 1 et, ici, d'en autoriser la commande à distance. Le circuit de commande 41 assure aussi des fonctions de mesure et de protection.

Dans cet exemple, le circuit de commande 41 comporte un circuit électronique incluant un calculateur électronique, tel qu'un microprocesseur ou un microcontrôleur programmable, ainsi qu'un support d'enregistrement d'information, tel qu'une mémoire informatique non-volatile, par exemple de technologie FLASH, pour stocker des valeurs de paramétrage et/ou des instructions exécutables pour assurer le fonctionnement du circuit de commande 41.

Le circuit de commande 41 comporte également une interface d'échange de données, adaptée pour être connectée à une liaison de données extérieure, par exemple pour recevoir un ordre de commande et/ou pour transmettre des données mesurées.

Dans cet exemple, le module 4 est raccordé à un bus de données 44 filaire, tel qu'un bus de terrain. L'interface d'échange de données du circuit de commande 41 est donc connectée à ce bus de données 44.

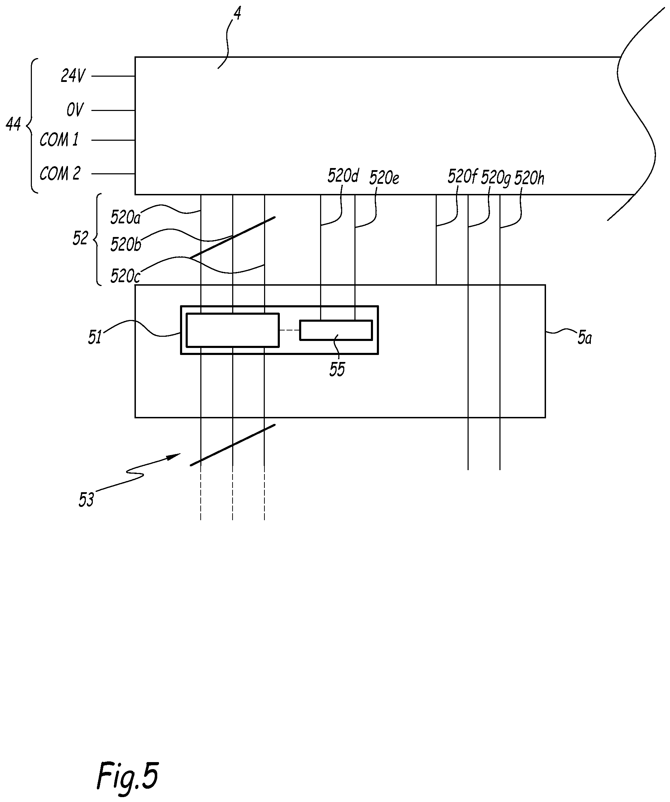

A titre d'exemple illustratif, le bus de données 44 comporte ici quatre conducteurs chacun associé à un signal électrique 24V, 0V, COM1 et COM2 (Figure 5).

En particulier, le circuit de commande 41 est ici programmé pour déclencher l'ouverture du disjoncteur 31 en fonction de valeurs du courant électrique qui circule dans les deuxièmes lignes de puissance 40a, 40b, 40c, 40d, par exemple lorsque l'intensité du courant circulant dans l'une des deuxièmes lignes de puissance 40a, 40b, 40c, 40d dépasse un seuil prédéfini.

A cet effet, le deuxième module 4 comporte des capteurs de courant 43 chacun associé à une des deuxièmes lignes de puissance 40a, 40b, 40c, 40d, chaque capteur 43 étant ici adapté pour mesurer le courant qui circule sur chacune des phases de cette ligne de puissance. Par exemple, chaque capteur 43 comporte des capteurs de courant de type Rogowski. Les capteurs 43 sont connectés à une interface d'acquisition de données du circuit de commande 41.

Le circuit de commande 41 est ici connecté au déclencheur 34 par l'intermédiaire de la liaison de données 36. Par exemple, cette liaison 36 est une liaison câblée, formée par association de deux parties distinctes, appartenant respectivement aux modules 3 et 4, et raccordées entre elles par un connecteur approprié, ici porté par le support 2, qui met en connexion ces deux parties distinctes lorsque les modules 3 et 4 sont tous deux dans leur position assemblée.

Le deuxième module 4 comporte également une interface de commande 42, connectée au circuit 41 et disposée sur une face extérieure du module 4 pour permettre à un opérateur de paramétrer le fonctionnement du circuit de commande 41, par exemple pour sélectionner la valeur de seuil de courant précité pour le déclenchement du disjoncteur 41.

Par exemple, l'interface 42 comporte un ou plusieurs boutons de sélection rotatifs, destinés à être utilisés par un opérateur pour choisir une ou plusieurs valeurs de seuil de courant.

En variante, l'interface 42 peut comporter une interface homme-machine numérique, incluant par exemple un écran d'affichage, par exemple électronique, et des boutons de sélection.

Le circuit de commande 41 est avantageusement également programmé pour assurer d'autres fonctions, par exemple de diagnostic et/ou de surveillance du fonctionnement du dispositif 1. Par exemple, le circuit de commande 41 collecte des grandeurs électriques mesurées telles que la tension électrique entre les phases d'une ligne de puissance, et/ou la puissance électrique transitant par chaque ligne de puissance.

En outre, le circuit de commande 41 est programmé pour commander le fonctionnement des modules 5a, 5b 5c et 5d, en envoyant un signal de commande, comme expliqué dans ce qui suit. Cette commande est ici réalisée au moyen de liaisons de données 45, chacune connectant un des éléments amovibles 5a, 5b, 5c et 5d au circuit de commande 41. Par exemple, le signal de commande est une tension électrique. La liaison 45 comporte alors deux conducteurs électriques entre lesquels la tension électrique correspondante est appliquée.

Les éléments amovibles 5a, 5b, 5c et 5d, aussi nommés cassettes amovibles, contiennent chacun un équipement électrique commandable. Chacun de ces équipements électriques est destiné à être connecté à une des deuxièmes lignes de puissance 40a, 40b, 40c et 40d, par exemple en vue d'agir sur le fonctionnement des appareils électriques de puissance alimentés par ces lignes de puissance. Par exemple, les éléments amovibles 5a, 5b, 5c et 5d sont placés en-dessous du deuxième module 4.

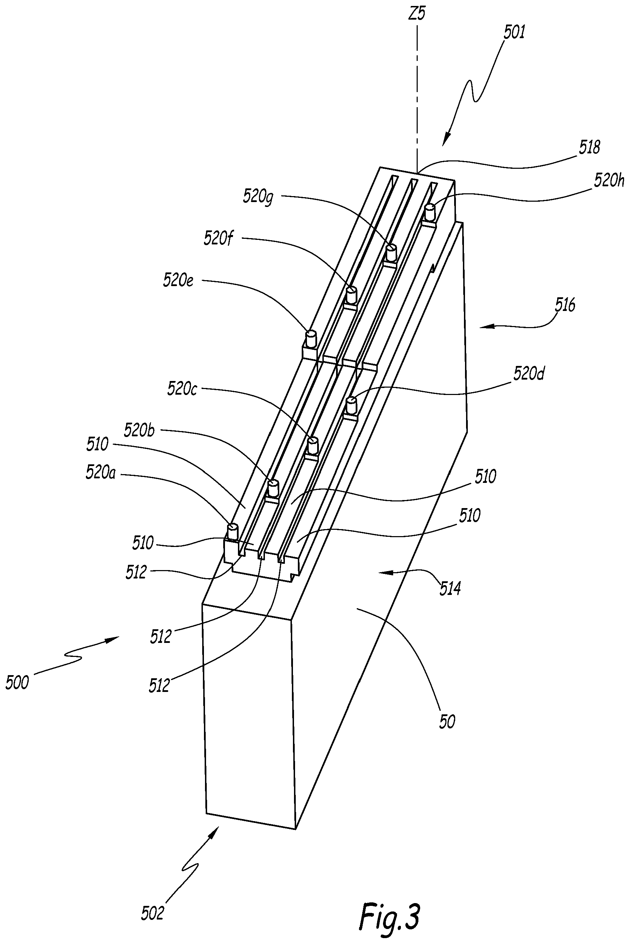

Dans cet exemple, les éléments amovibles 5a, 5b, 5c et 5d sont identiques. Aussi, seul un de ces éléments amovibles, en l'occurrence l'élément 5d, est illustré aux figures 2 et 3.

Dans cet exemple, les équipements électriques contenus dans les éléments amovibles 5a, 5b, 5c et 5d sont des contacteurs 51 commandables. Chaque contacteur 51 comporte ainsi des contacts électriques séparables et une interface de commande 55, telle qu'un actionneur commandable à électroaimant.

Les contacts séparables de chaque contacteur 51 sont connectés électriquement aux conducteurs de la deuxième ligne de puissance 40a, 40b, 40c et 40d correspondante, au moyen d'une liaison de puissance 52, décrite ci-après, lorsque l'élément amovible est dans la position assemblée.

Chaque contacteur 51 est commutable entre un état ouvert et un état fermé, pour, respectivement, empêcher ou autoriser la circulation d'un courant électrique depuis cette deuxième ligne de puissance vers l'appareil électrique correspondant. Cette commutation est indépendante de celle du disjoncteur 31. Plus précisément, la commutation de chaque contacteur 51 est assurée grâce à l'actionneur correspondant, en réponse à un signal de commande, ici fourni par le circuit de commande 41 au travers de la liaison 45.

De cette manière, grâce à ces contacteurs 51, l'alimentation d'un ou plusieurs des appareils électriques de puissance connectés en aval du dispositif 1 peut être interrompue sélectivement.

Ainsi, dans ce mode de réalisation, le signal de commande pour ouvrir ou fermer un contacteur 51 est envoyé par le circuit de commande 41, en réponse à un ordre de commande correspondant reçu grâce au bus de données 44.

Comme illustré à la figure 3, chaque élément amovible 5a, 5b, 5c et 5d comporte un boîtier 50 à l'intérieur duquel est logé l'équipement électrique commandable. Ce boîtier 50 est par exemple réalisé dans un matériau analogue à celui du boîtier 37 et/ou du boîtier 46. On note « 501 » une face avant et « 502 » une face arrière de cet élément amovible 5d. Ce boîtier 50 comporte ici une forme de pavé présentant une largeur L3, mesurée sur une base de la face avant de cet élément amovible 5d, est égale au quart de la largeur L2 du deuxième module 4. Le boîtier 50 est ici surmonté par une portion de connexion 500, formant une interface de connexion au deuxième module 4, aussi nommée interface 500 dans ce qui suit.

Les éléments amovibles 5a, 5b, 5c et 5d contiennent chacun une interface de raccordement, par exemple située sur une base du boîtier 50, contenant des terminaux de sortie 53 qui sont destinés à relier électriquement l'équipement électrique commandable à l'appareil électrique correspondant.

Les éléments amovibles 5a, 5b, 5c et 5d sont destinés à être associées, de façon amovible, au deuxième module 4. A cet effet, le deuxième module 4 comporte une interface 47 de connexion des éléments amovibles 5a, 5b, 5c et 5d. Les interfaces 47 et 500 ont ainsi pour fonction d'assurer une connexion mécanique et une connexion électrique entre le deuxième module 4 et l'élément amovible correspondant.

Dans cet exemple, l'interface 47 comporte plusieurs logements 471, délimités au moins en partie par des parois de séparation 472, par exemple formées d'un seul tenant avec le boîtier 46. Les logements 471 sont ici au nombre de quatre et sont identiques entre eux.

Chaque élément amovible 5a, 5b, 5c et 5d est déplaçable, de façon réversible, entre une position assemblée, dans laquelle il est reçu dans un logement 471, et une position retirée, dans laquelle il est séparé de son logement 471.

A titre d'exemple, le déplacement entre les positions assemblée et retirée est réalisé par un mouvement de translation, ici selon une direction dite de déplacement perpendiculaire au fond du support 2, de préférence de façon analogue au déplacement des modules 3 et 4. Sur la figure 1, les éléments 5a, 5b et 5c sont montrés dans leurs positions assemblées, alors que l'élément 5d est illustré partiellement retiré hors du logement 471.

L'interface 47 comporte un dispositif de guidage en translation, incluant ici des rainures 474 qui s'étendent selon la direction de déplacement. Ces rainures 474 sont ici identiques et parallèles entre elles. Les rainures 474 sont séparées les unes des autres par des languettes 475, qui s'étendent ici verticalement. Les rainures 474 sont de préférence ménagées dans une zone inférieure du deuxième module 4. Les rainures 474 s'étendent ici longitudinalement entre les faces arrière et avant du module 4, perpendiculairement à ces faces arrière et avant et débouchent sur la face avant du deuxième module 4. Les rainures 474 dessinent ici un profil crénelé dans une section transversale parallèle à la face avant du module 4.

De façon complémentaire, l'interface 500 de chaque élément amovible 5a, 5b, 5c et 5d comporte des murs 510 longitudinaux et parallèles, qui s'étendent en saillie par rapport à une face extérieure et selon un axe vertical Z5 de cet élément amovible 5a, 5b, 5c et 5d. Ces murs 510 délimitent des gorges 512, elles aussi longitudinales et parallèles, qui sont séparées les unes des autres par les murs 510, formant ainsi un dispositif de guidage destiné à coopérer avec les rainures 474 et les languettes 475 pour autoriser le mouvement en translation.

Comme illustré à la figure 1, lorsque l'interface 500 coopère avec l'interface 47, les languettes 475 pénètrent à l'intérieur des gorges 512. Les murs 510 sont quant à eux reçus dans les rainures 474.

Dans cet exemple, l'interface 500 contient trois rainures 512 et quatre murs 510.

Le jeu entre les gorges 512 et les languettes 475 est choisi de façon à autoriser le déplacement en translation de l'élément amovible 5a, 5b, 5c, 5d par rapport au module 4.

Dans cet exemple, l'interface 500 comporte une première zone 514 et une deuxième zone 516 adjacentes l'une avec l'autre dans le sens de la longueur de l'élément amovible 5a, 5b, 5c et 5d. La zone 516 est ici du côté de la face avant 501, alors que la zone 514 est ici du côté de la face arrière 502. Les murs 510 s'étendent chacun dans les zones 514 et 516 et présentent une surélévation parallèlement à l'axe Z5 dans la zone 516.Les interfaces 47 et 500 permettent également une connexion électrique entre le deuxième module 4 et l'équipement électrique de l'élément amovible 5a, 5b, 5c, 5d correspondant, de manière à permettre une circulation du courant électrique d'alimentation par une liaison de puissance 52 et un échange de données par la liaison 45.

A cet effet, l'interface 47 comporte des connecteurs de sortie de puissance 473 raccordés aux deuxièmes lignes de puissance 40a, 40b, 40c et 40d. Dans cet exemple, l'interface 47 comporte plusieurs tels connecteurs 473 chacun connecté à un conducteur d'une deuxième ligne de puissance 40a, 40b, 40c et 40d. Ces connecteurs 473 ne sont représentés que de façon schématique à la figure 2.

L'interface 500 comporte des connecteurs 520, ici en forme de plots métalliques et de préférence identiques entre eux. Ces connecteurs s'étendent en saillie par rapport à une face supérieure de l'interface 500, ici chacun depuis la face supérieure d'un mur 510. Ces connecteurs 520 sont répartis de façon décalée selon la direction de déplacement, de manière à ce que deux connecteurs placés sur des murs 510 immédiatement voisins ne soient pas trop proches l'un de l'autre. Par exemple, la distance entre les centres de deux conducteurs 520 immédiatement voisins est strictement supérieure à la distance entre les deux murs 510 sur lesquels ces conducteurs 520 sont ménagés. Les connecteurs 473 et 45 sont préférentiellement disposés de façon correspondante sur l'interface 47.

Dans cet exemple, chaque interface 500 comporte huit connecteurs 520, notés 520a à 520f.

Comme illustré à la figure 5, les connecteurs 520a, 520b et 520c sont ici chacun associé avec une phase électrique et forment ainsi la liaison 52 de puissance destinée à être connectée avec la deuxième ligne de puissance 40a, 40b, 40c et 40d correspondante du deuxième module 4 pour assurer une circulation du courant d'alimentation vers cet élément amovible. Ainsi, les connecteurs 520a, 520b et 520c sont raccordés à une entrée de l'élément électrique 51 correspondant et sont destinés à être connectés aux connecteurs 473 d'une des deuxièmes lignes de puissance.

Les connecteurs 520a, 520b et 520c sont ici de préférence groupés vers l'arrière de l'élément amovible, de manière à éviter qu'ils ne soient accidentellement accessibles par un utilisateur du dispositif 1.

Les connecteurs 520d, 520e 520f, 520g et 520h servent ici à assurer un transfert de données et/ou sont inactifs et servent notamment à former la liaison 45.

Par exemple, les connecteurs 520d et 520e sont raccordés à l'interface de commande 55 de l'élément amovible correspondant et sont destinés à être connectés aux connecteurs de la liaison de données 45 pour assurer la transmission du signal de commande émis par le circuit de commande 41.

Dans l'exemple illustré, le connecteur 520f est ici maintenu à une tension nulle. Le connecteur 520g et le 520h permettent ici d'assurer une commande locale de l'interface 55 en cas de défaillance du module 4. En variante, ils peuvent être omis.

Les autres connecteurs peuvent avoir d'autres fonctions, certains d'entre eux pouvant être inactifs dans certains modes de réalisation.

D'autres modes de réalisation sont cependant possibles, dans lesquels le nombre et la fonction des connecteurs 520 de l'interface 500 sont différents selon la fonctionnalité de l'équipement électrique embarqué dans l'élément amovible.

Grâce à cette disposition, lorsque l'élément amovible est reçu dans un des logements 471, les languettes 475 assurent une séparation entre les connecteurs 520, ce qui assure une isolation électrique entre ces connecteurs. En outre, leur disposition de façon décalée permet d'espacer suffisamment les contacts voisins pour assurer une isolation électrique malgré l'espace réduit au niveau de l'interface 500.

Avantageusement, comme illustré à la figure 3, l'interface 500 comprend un bord d'extrémité 518 qui bouche l'extrémité des gorges 512 au niveau de la face avant 501. Cela permet d'éviter qu'un utilisateur ne puisse accéder aux connecteurs 520 depuis la face avant de l'appareil 1 lorsque l'élément amovible 5a, 5b, 5c et 5d est connecté au deuxième module 4.

La construction modulaire du dispositif 1 permet un remplacement aisé d'une partie du dispositif 1, par exemple pour réaliser des opérations de maintenance, sans affecter les autres constituants du dispositif 1. Elle permet également de remplacer une partie des constituants, par exemple pour les remplacer par de nouveaux constituants présentant des fonctionnalités améliorées afin de réaliser une mise à niveau du dispositif 1 tout en conservant les autres constituants qui n'ont pas besoin d'être remplacés.

En outre, le fait de loger le circuit de distribution 40 dans le deuxième module 4 permet une plus grande flexibilité d'utilisation des éléments amovibles 5a, 5b, 5c et 5d.

Le contacteur 35 précédemment décrit est ici destiné à être commandé en cas de défaillance de l'un des contacteurs 51, notamment lorsqu'un contacteur 51 ne s'ouvre pas alors qu'il a reçu un signal de commande le lui commandant de commuter en position ouverte.

Ce contacteur 35 comporte des contacts séparables dont le fonctionnement est similaire à celui des contacteurs 51, mis à part qu'il agit sur la première ligne de puissance 30 et cause donc l'interruption du courant électrique vers toutes les lignes de puissance lorsqu'il commute vers sa position ouverte.

Le circuit de commande 41 est par exemple programmé pour envoyer un signal de commande de fermeture ou d'ouverture du contacteur 35 dans un tel cas, au moyen de la liaison de données 36.

De préférence, le contacteur 35 est logé au sein de la chambre de coupure d'arc du disjoncteur 31, ce qui évite d'avoir à utiliser deux chambres de coupure distinctes et simplifie donc la conception du dispositif 1.

Ce contacteur 35 permet ainsi d'assurer une redondance des contacteurs 51, de façon plus simple et moins coûteuse qu'en ajoutant un contacteur additionnel pour chacune des deuxièmes lignes de puissance. Ce contacteur 35 peut toutefois être omis, notamment lorsque les éléments amovibles 5a, 5b, 5c et 5d ne contiennent pas de contacteur 51.

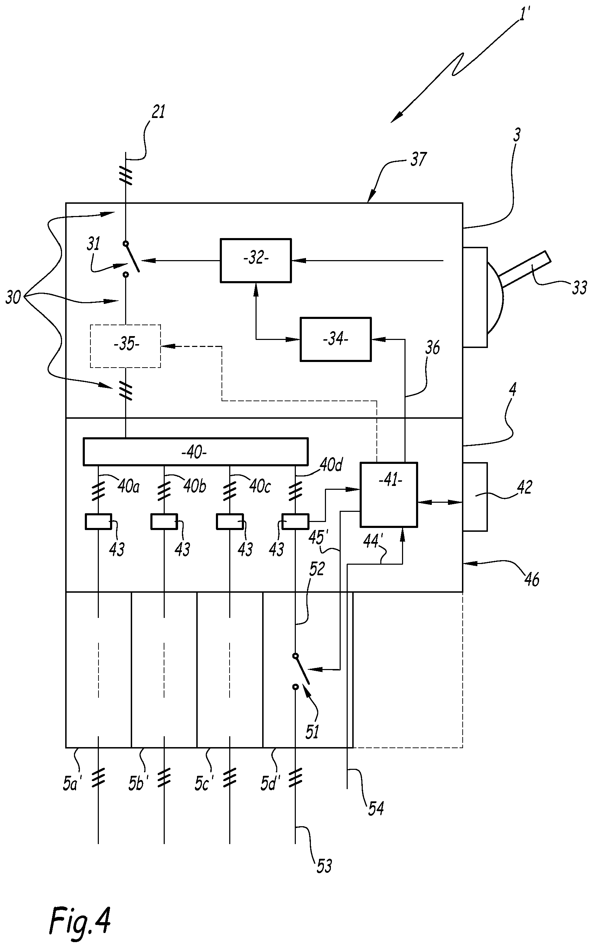

La figure 4 représente un dispositif électrique 1' selon un deuxième mode de réalisation de l'invention. Les éléments du dispositif 1' qui sont analogues au dispositif 1 du premier mode de réalisation portent les mêmes références et ne sont pas décrits en détail, dans la mesure où la description ci-dessus peut leur être transposée.

Le dispositif 1' diffère notamment du dispositif 1 dans la façon dont les éléments amovibles sont commandés par le circuit de commande 41. Ces éléments amovibles portent ici les références 5a', 5b', 5c' et 5d' et remplacent, respectivement, les éléments amovibles 5a, 5b, 5c et 5d.

Plus précisément, au sein du dispositif 1', le bus de données 44 est omis. Chaque élément amovible 5a', 5b', 5c' et 5d' comporte un terminal d'entrée de données 54, destiné à recevoir un ordre de commande et par exemple ménagé dans la zone de raccordement de chaque élément amovible 5a', 5b', 5c' et 5d'. Le terminal 54 est connecté au circuit de commande 41 par l'intermédiaire d'une liaison de données montante 44' formée par la connexion d'une première partie de liaison portée par l'élément amovible et d'une deuxième partie de liaison portée par le module 4, ces parties de liaison étant connectées entre elle par l'intermédiaire des connecteurs 520 lorsque l'élément amovible est reçu dans le logement 471 dans la position assemblée. De façon analogue, l'interface de commande de l'actionneur est connectée au circuit de commande 41 par l'intermédiaire d'une liaison de données descendante 45' qui remplace la liaison de données 45. Cette liaison 45' est par exemple construite de façon analogue à la liaison de données 45. Mis à part ces différences, le fonctionnement des éléments amovibles 5a', 5b', 5c' et 5d' est analogue à celui des éléments amovibles 5a, 5b, 5c et 5d.

Ainsi, dans ce mode de réalisation, à la différence du premier mode de réalisation, l'ordre de commande envoyé vers le dispositif 1' pour piloter un élément amovible est transmis par l'intermédiaire du terminal d'entrée 54 associé à cet élément amovible, puis transite à destination du circuit de commande 41 par l'intermédiaire de la liaison de données montante 44'. En réponse, le circuit de commande 41' génère un ordre de commande qui est envoyé à l'élément amovible correspondant par la liaison de données descendante 45'.

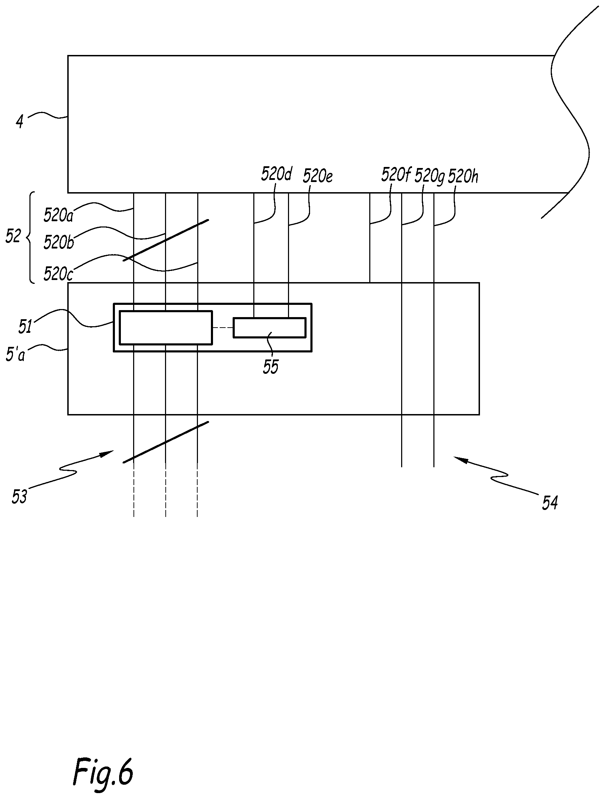

Dans ce cas, le rôle de certains des conducteurs 520 peut être différent. Par exemple, comme illustré à la figure 6, les connecteurs 520g et 520h servent ici à transmettre le signal de commande reçu depuis l'extérieur de l'élément amovible, en formant la liaison de données montante 44'. La liaison 45' est quant à elle formée grâce aux conducteurs 520d, 520e qui sont destinés à être connectés à l'interface 55.

D'autres modes de réalisation sont possibles. Le nombre des éléments amovibles 5a, 5b, 5c et 5d peut être différent. Par exemple, ces éléments amovibles sont au nombre de trois ou de cinq, voire de deux. Le nombre de logements 471 de l'interface 47 est alors modifié en conséquence. Dans ce cas, la taille des éléments amovibles et des logements 471 peut être adaptée en conséquence. Par exemple, lorsque le dispositif 1 est destiné à ne recevoir que deux éléments amovibles, alors les logements 471 peuvent présenter une largeur L3 égale à la moitié de la largeur L2.

Les équipements électriques des éléments amovibles 5a, 5b, 5c et 5d peuvent être autre chose qu'un contacteur 51. Par exemple, il s'agit d'un inverseur de sens de marche ou de rotation. Dans ce cas, l'élément amovible correspondant n'est pas nécessairement connecté à des deuxièmes lignes de puissance. De ce fait, il peut occuper deux logements 471. En variante, il peut s'agir d'un module d'entrée/sortie de données. Les connecteurs 520 peuvent alors avoir une fonction différente de celle précédemment décrite.

A titre d'exemple illustratif, dans le cas où l'équipement électrique est un inverseur de source, alors le connecteur 520d est maintenu à un potentiel électrique de 24V, les connecteurs 520e et 520f transmettent, respectivement, les informations provenant des conducteurs COM1 et COM2 du bus de données 44, et le connecteur 520h permet d'acheminer un signal d'identification émis par l'inverseur de source et permettant au circuit de commande 41 d'identifier l'inverseur de source.

Avantageusement, le deuxième module 4 comporte des moyens de détection de la nature de l'équipement électrique contenu dans l'élément amovible 5a, 5b, 5c, 5d. Ces moyens de détection peuvent être de type mécanique ou électrique.

Les moyens de détection de type mécanique comportent par exemple un palpeur mécanique ménagé dans l'interface 47 et qui est adapté pour coopérer avec un organe de forme complémentaire placé sur l'interface 500 et pour se déplacer selon une course prédéfinie sous l'action de cet organe lorsqu'un élément amovible est inséré dans le logement 471.

Les moyens de détection de type électronique comportent par exemple des moyens de réception et/ou de lecture d'un signal d'identification prédéfini. Ce signal d'identification est émis et/ou stocké par l'élément amovible correspondant.

Les modes de réalisation et les variantes envisagés ci-dessus peuvent être combinés entre eux pour générer de nouveaux modes de réalisation.

## Revendications

1. Dispositif électrique (1 ; 1') pour l'alimentation électrique de plusieurs appareils de puissance, comportant :
- un support fixe (2) ;
- des terminaux d'entrée (21) pour recevoir un courant électrique polyphasé ;
- un premier module (3), comprenant une première ligne de puissance (30) connectée aux terminaux d'entrée, cette ligne de puissance comprenant un disjoncteur électrique (31) ;
- un deuxième module (4) amovible, comprenant :
• des deuxièmes lignes de puissance (40a, 40b, 40c, 40d), connectées à la première ligne de puissance par l'intermédiaire d'un circuit de distribution électrique (40) configuré pour distribuer le courant électrique polyphasé depuis la première ligne de puissance vers chacune des deuxième lignes de puissance ;
• un circuit de commande (41), programmé pour déclencher le disjoncteur en fonction de valeurs du courant électrique qui circule dans les deuxièmes lignes de puissance ;
• une interface de connexion (47) pourvue de connecteurs de sortie (473) connectés aux deuxièmes lignes de puissance ;
- des éléments amovibles (5a, 5b, 5c, 5d) contenant chacun un équipement électrique (51) destiné à être connecté à un appareil électrique de puissance par l'intermédiaire de terminaux de sortie (53) de cet élément amovible,
chaque élément amovible (5a, 5b, 5c, 5d) étant déplaçable entre une position assemblée, dans laquelle il est connecté à l'interface de connexion, et une position retirée dans laquelle il est retiré de l'interface de connexion,
l'équipement électrique (51) étant connecté à une des deuxièmes lignes de puissance par l'intermédiaire des connecteurs de sortie (473) de l'interface de connexion (47) lorsque l'élément amovible (5a, 5b, 5c, 5d) est dans la position assemblée,
le circuit de commande (41) étant connecté à une interface de commande de l'équipement électrique (51) de chaque élément amovible (5a, 5b, 5c, 5d) par l'intermédiaire d'une liaison de données (45 ; 45') grâce à l'interface de connexion (47) pour envoyer un signal de commande à destination de cet équipement électrique (51).

2. Dispositif (1 ; 1') selon la revendication 1, **caractérisé en ce que** l'élément électrique commandable est un contacteur (51) à contacts séparables adapté pour sélectivement interrompre la circulation d'un courant électrique sur la deuxième ligne de puissance à laquelle il est connecté.

3. Dispositif (1 ; 1') selon la revendication 1, **caractérisé en ce que** l'élément électrique commandable est un inverseur de sens de marche ou de rotation ou un module d'entrée/sortie de données.

4. Dispositif (1 ; 1') selon l'une quelconque des revendications précédentes, **caractérisé en ce que** l'interface de connexion (47) comporte des logements (471) chacun destiné à recevoir une portion de connexion (500) d'un des éléments amovibles (5a, 5b, 5c, 5d) lorsque cet élément amovible est dans la position assemblée.

5. Dispositif (1 ; 1') selon l'une quelconque des revendications précédentes, **caractérisé en ce que** le deuxième module (4) est connecté à un bus de données (44) et **en ce que** le circuit de commande (41) est programmé pour envoyer un signal de commande en fonction d'ordres de commande reçus depuis le bus de données.

6. Dispositif (1') selon l'une quelconque des revendications 1 à 4, **caractérisé en ce que** chaque élément amovible (5a', 5b', 5c' et 5d') comporte un terminal d'entrée de données (54) pour recevoir un ordre de commande, ce terminal d'entrée de données (54) étant raccordé à une première partie de liaison, et **en ce que** le deuxième module (4) comporte une deuxième partie de liaison connectée à l'unité de commande (4)

7. Dispositif (1 ; 1') selon l'une quelconque des revendications précédentes, **caractérisé en ce que** la portion (500) de connexion de chaque élément amovible (5a, 5b, 5c, 5d) comporte des connecteurs (511, 511', 511") de forme complémentaire à celle des connecteurs de sortie (473) et formés en saillie par rapport à la portion (500) de connexion, la connexion électrique entre l'équipement électrique et la deuxième de puissance correspondante étant assurée par l'intermédiaire de ces connecteurs.

8. Dispositif (1 ; 1') selon l'une quelconque des revendications précédentes, **caractérisé en ce que** l'interface de connexion (47) et la portion de connexion (500) de chaque élément amovible (5a, 5b, 5c, 5d) comportent des dispositifs de guidage en translation de forme complémentaire l'un par rapport à l'autre pour assurer un déplacement en translation de cet élément amovible par rapport au deuxième module (4).

9. Dispositif (1 ; 1') selon l'une quelconque des revendications 2 et 4 à 8, **caractérisé en ce que** le premier module (3) comporte un contacteur additionnel (35) connecté à la première ligne de puissance (30) et adapté pour être commandé par le circuit de commande (41).

10. Dispositif (1 ; 1') selon l'une quelconque des revendications précédentes, **caractérisé en ce que** le premier module (3) est amovible.

## Patentansprüche

1. Elektrische Vorrichtung (1; 1') zur elektrischen Versorgung mehrerer Leistungsvorrichtungen, aufweisend:
- ein festes Auflager (2);
- Eingangsklemmen (21) zum Aufnehmen eines mehrphasigen elektrischen Stroms;
- ein erstes Modul (3), umfassend eine erste Stromleitung (30), die mit den Eingangsklemmen verbunden ist, wobei diese Stromleitung einen elektrischen Schutzschalter (31) umfasst;
- ein zweites abnehmbares Modul (4), umfassend:
• zweite Stromleitungen (40a, 40b, 40c, 40d), die mit der ersten Stromleitung über eine elektrische Verteilerschaltung (40) verbunden sind, die ausgelegt ist, um mehrphasigen elektrischen Strom von der ersten Stromleitung auf jede der zweiten Stromleitungen zu verteilen;
• eine Steuerungsschaltung (41), die programmiert ist, um den Schutzschalter entsprechend den Werten des in den zweiten Stromleitungen fließenden elektrischen Stroms abzuschalten;
• eine Anschlussschnittstelle (47), die mit Ausgangssteckern (473) versehen ist, die mit den zweiten Stromleitungen verbunden sind;
- entfernbare Elemente (5a, 5b, 5c, 5d), die jeweils elektrische Geräte (51) enthalten, die dazu vorgesehen sind, über Ausgangsklemmen (53) des entfernbaren Elements mit einer elektrischen Leistungsvorrichtung verbunden zu werden,
wobei jedes entfernbare Element (5a, 5b, 5c, 5d) zwischen einer montierten Position, in der es mit der Anschlussschnittstelle verbunden ist, und einer herausgezogenen Position, in der es aus der Anschlussschnittstelle herausgezogen ist, bewegbar ist,
wobei das elektrische Gerät (51) über die Ausgangsstecker (473) der Anschlussschnittstelle (47) mit einer der zweiten Stromleitungen verbunden ist, wenn sich das entfernbare Element (5a, 5b, 5c, 5d) in der montierten Position befindet,
wobei die Steuerungsschaltung (41) mit einer Steuerschnittstelle des elektrischen Geräts (51) jedes entfernbaren Elements (5a, 5b, 5c, 5d) über eine Datenverbindung (45; 45') durch die Anschlussschnittstelle (47) verbunden ist, um ein Steuersignal an das elektrische Gerät (51) zu senden.

2. Vorrichtung (1; 1') nach Anspruch 1, **dadurch gekennzeichnet, dass** das steuerbare elektrische Element ein Schütz (51) mit trennbaren Kontakten ist, der geeignet ist, den Fluss eines elektrischen Stroms auf der zweiten Stromleitung, an die er angeschlossen ist, selektiv zu unterbrechen.

3. Vorrichtung (1; 1') nach Anspruch 1, **dadurch gekennzeichnet, dass** das steuerbare elektrische Element ein Richtungs- oder Drehwandler oder ein Datenein-/Ausgabemodul ist.

4. Vorrichtung (1; 1') nach einem der vorangegangenen Ansprüche, **dadurch gekennzeichnet, dass** die Anschlussschnittstelle (47) Gehäuse (471) aufweist, die dazu vorgesehen sind, jeweils einen Anschlussabschnitt (500) eines der entfernbaren Elemente (5a, 5b, 5c, 5d) aufzunehmen, wenn sich dieses entfernbare Element in der montierten Position befindet.

5. Vorrichtung (1; 1') nach einem der vorangegangenen Ansprüche, **dadurch gekennzeichnet, dass** das zweite Modul (4) mit einem Datenbus (44) verbunden ist und dass die Steuerungsschaltung (41) programmiert ist, ein Steuersignal entsprechend den von dem Datenbus empfangenen Steuerbefehlen zu senden.

6. Vorrichtung (1') nach einem der Ansprüche 1 bis 4, **dadurch gekennzeichnet, dass** jedes entfernbare Element (5a', 5b', 5c' und 5d') eine Dateneingangsklemme (54) zum Empfangen eines Steuerbefehls aufweist, wobei diese Dateneingangsklemme (54) mit einem ersten Verbindungsteil verbunden ist, und dass das zweite Modul (4) ein mit der Steuereinheit (4) verbundenes zweites Verbindungsteil aufweist.

7. Vorrichtung (1; 1') nach einem der vorangegangenen Ansprüche, **dadurch gekennzeichnet, dass** der Anschlussabschnitt (500) jedes entfernbaren Elements (5a, 5b, 5c, 5d) Stecker (511, 511', 511") mit einer Form aufweist, die zu der der Ausgangsstecker (473) komplementär ist, die in Bezug auf den Anschlussabschnitt (500) hervorstehend ausgebildet sind, wobei die elektrische Verbindung zwischen dem elektrischen Gerät und der zweiten entsprechenden Leistung durch diese Stecker gewährleistet ist.

8. Vorrichtung (1; 1') nach einem der vorangegangenen Ansprüche, **dadurch gekennzeichnet, dass** die Anschlussschnittstelle (47) und der Anschlussabschnitt (500) jedes entfernbaren Elements (5a, 5b, 5c, 5d) Mittel zur translatorischen Führung von zueinander komplementärer Form aufweisen, um eine translatorische Verschiebung dieses entfernbaren Elements gegenüber dem zweiten Modul (4) zu gewährleisten.

9. Vorrichtung (1; 1') nach einem der Ansprüche 2 und 4 bis 8, **dadurch gekennzeichnet, dass** das erste Modul (3) ein zusätzliches Schütz (35) aufweist, das mit der ersten Stromleitung (30) verbunden und von der Steuerungsschaltung (41) steuerbar ist.

10. Vorrichtung (1; 1') nach einem der vorhergehenden Ansprüche, **dadurch gekennzeichnet, dass** das erste Modul (3) entfernbar ist.

## Claims

1. Electrical device (1; 1') for supplying electrical power to a plurality of power units, comprising:
- a fixed support (2);
- input terminals (21) for receiving a polyphase electric current;
- a first module (3) comprising a first power line (30) connected to the input terminals, the power line comprising an electrical circuit breaker (31);
- a second, removable module (4) comprising:
• second power lines (40a, 40b, 40c, 40d) which are connected to the first power line by way of an electrical distribution circuit (40) which is configured to distribute the polyphase electric current from the first power line to each of the second power lines;
• a control circuit (41) which is programmed to trigger the circuit breaker as a function of values of the electric current which is flowing through the second power lines;
• a connection interface (47) provided with output connectors (473) connected to the second power lines;
- removable elements (5a, 5b, 5c, 5d) each containing a piece of electrical equipment (51) which is to be connected to an electrical power unit by way of output terminals (53) of the removable element,
each removable element (5a, 5b, 5c, 5d) being displaceable between an assembled position, in which it is connected to the connection interface, and a removed position, in which it is removed from the connection interface,
the piece of electrical equipment (51) being connected to one of the second power lines by way of the output connectors (473) of the connection interface (47) when the removable element (5a, 5b, 5c, 5d) is in the assembled position,
the control circuit (41) being connected to a control interface of the piece of electrical equipment (51) of each removable element (5a, 5b, 5c, 5d) by way of a data link (45; 45') by virtue of the connection interface (47) in order to send a control signal to the piece of electrical equipment (51).

2. Device (1; 1') according to claim 1, **characterised in that** the controllable electrical element is a contactor (51) with separable contacts which is adapted to selectively interrupt the flow of an electric current on the second power line to which it is connected.

3. Device (1; 1') according to claim 1, **characterised in that** the controllable electrical element is a direction of travel or rotation inverter or a data input/output module.

4. Device (1; 1') according to any one of the preceding claims, **characterised in that** the connection interface (47) comprises receivers (471), each of which is to receive a connection portion (500) of one of the removable elements (5a, 5b, 5c, 5d) when that removable element is in the assembled position.

5. Device (1; 1') according to any one of the preceding claims, **characterised in that** the second module (4) is connected to a data bus (44), and **in that** the control circuit (41) is programmed to send a control signal as a function of control commands received from the data bus.

6. Device (1') according to any one of claims 1 to 4, **characterised in that** each removable element (5a', 5b', 5c' and 5d') comprises a data input terminal (54) for receiving a control command, the data input terminal (54) being connected to a first linking portion, and **in that** the second module (4) comprises a second linking portion connected to the control unit (4).

7. Device (1; 1') according to any one of the preceding claims, **characterised in that** the connection portion (500) of each removable element (5a, 5b, 5c, 5d) comprises connectors (511, 511', 511") whose shape is complementary to that of the output connectors (473) and which are formed to project relative to the connection portion (500), the electrical connection between the piece of electrical equipment and the corresponding second power being provided by way of these connectors.

8. Device (1; 1') according to any one of the preceding claims, **characterised in that** the connection interface (47) and the connection portion (500) of each removable element (5a, 5b, 5c, 5d) comprise devices for guiding during translation which are of mutually complementary shapes in order to effect displacement by translation of the removable element relative to the second module (4).

9. Device (1; 1') according to any one of claims 2 and 4 to 8, **characterised in that** the first module (3) comprises an additional contactor (35) which is connected to the first power line (30) and adapted to be controlled by the control circuit (41).

10. Device (1; 1') according to any one of the preceding claims, **characterised in that** the first module (3) is removable.
